# EUROPEAN PATENT APPLICATION

(11) **EP 2 363 868 A2**
(43) Date of publication of application: **07.09.2011**
(21) Application number: 11152759.4
(22) Date of filing: 31.01.2011
(51) Int. Cl.: H01G 9/20

(54) **Method of adsorbing dye to metal oxide particle by using supercritical fluid**

(30) Priority: 04.03.2010 KR 20100019563
(71) Applicant: Samsung SDI Co., Ltd., Yongin-si, Gyeonggi-do (KR)
(72) Inventor: Shin, Byong-Cheol, Gyeonggi-do (KR); Lee, Ji-Won, Gyeonggi-do (KR); Kang, Moon-Sung, Gyeonggi-do (KR); Nam, Jae-Do, Gyeonggi-do (KR); Lee, Jun-Ho, Gyeonggi-do (KR)
(74) Representative: Walaski, Jan Filip

(57) **Abstract**

A method of adsorbing dye to a metal oxide particle by using a supercritical fluid, and a solar cell prepared using the method.

## Description

The following description relates to a method of adsorbing dye to a metal oxide by using a supercritical fluid, and a dye-sensitized solar cell including a metal oxide which adsorbs dye by using the above method.

A dye-sensitized solar cell includes an optical electrode which adsorbs photosensitive dye, an electrolyte including an oxidation/reduction ion pair, and an opposite electrode including platinum (Pt) catalyst. The optical electrode uses a metal oxide particle having wide band gap energy.

When sunlight is incident on the dye-sensitized solar cell, the photosensitive dye enters an excitation state to transfer electrons to a conduction band of a metal oxide. The transferred electrons flow to an external circuit to transfer electric energy so that an energy state of the electron is lowered by as much as the transferred electric energy, and then the electrons are moved to the opposite electrode.

Then, the photosensitive dye receives electrons from an electrolyte solution, the number of which is the same as the number of the electrons transferred to the metal oxide, and the photosensitive dye enters an original state. In this case, the electrolyte receives electrons from the opposite electrode by an oxidation-reduction reaction, and transfers the electrons to the photosensitive dye.

Dye is adsorbed into a cavity of a metal oxide particle such as TiO₂. Generally, the dye is maintained for about 24 hours under a condition where only gravity acts on the adsorption into the cavity of the metal oxide particle. However, this takes a long time, and thus there is a room for improvement.

An aspect of an embodiment of the present invention is directed toward a method of adsorbing dye to a metal oxide particle for a short period of time.

An aspect of an embodiment of the present invention is directed toward a dye-sensitized solar cell including a metal oxide particle which adsorbs dye by using the above method.

Additional aspects will be set forth in part in the description which follows and, in part, will be apparent from the description, or may be learned by practice of the presented embodiments.

According to one or more embodiments of the present invention, there is a method of adsorbing dye to a metal oxide particle by using a supercritical fluid.

The supercritical fluid may be selected from the group consisting of carbon dioxide, ethanol, methanol, propanol, ammonia and water.

The supercritical fluid may include carbon dioxide, and the dye is dissolved in ethanol, methanol or water so as to be used.

The method may be performed at a temperature in a range of about 60 to about 80°C and/or at a pressure in a range of about 100 to about 130 bar.

The metal oxide particle may include TiO₂, SnO₂, WO₃, ZnO, or a composite thereof.

According to one or more embodiments of the present invention, a dye-sensitized solar cell includes a metal oxide particle which adsorbs dye by using the method.

These and/or other aspects will become apparent and more readily appreciated from the following description of the embodiments, taken in conjunction with the accompanying drawings in which:
FIG. 1 is a graph for showing a phase change of a general material according to a temperature and a pressure;
FIG. 2 is a cross-sectional view of a dye-sensitized solar cell according to an embodiment of the present invention;
FIG. 3 is a schematic diagram of a supercritical device reactor used in an embodiment of the present invention; and
FIG. 4 is a graph showing an optical density for each wavelength of the dye-sensitized solar cells prepared in Examples 3 and 4, and Comparative Example 2.

A method of adsorbing dye to a TiO₂ layer including a mesoporous structure has been widely used to manufacture a dye-sensitized solar cell. A dipping method has been used as a method of adsorbing dye. However, due to structural characteristics, it is difficult to impregnate dye dissolved in a solvent into the mesoporous structure, and it takes a long time to perform an impregnation process.

The following description suggests a new method in which a large amount of dye may be adsorbed into a mesoporous structure by using a supercritical fluid having a diffusion force about 1000 times higher than liquid, and thus the efficiency of a solar cell is improved, and the time taken to perform a dye adsorption process is reduced from 24 hours or more to just several hours.

According to an embodiment of the present invention, dye is dissolved in a solvent, and then is adsorbed into a TiO₂ mesoporous (nanoporous) structure by using a supercritical fluid that may be mixed with the solvent, in order to control an amount of adsorbed dye when a solar cell is manufactured. The supercritical fluid has a high diffusion force compared to a typical dipping liquid, and therefore, limitations of the dipping method may be overcome in manufacturing a solar cell.

Up until now, a method of adsorbing dye of a dye-sensitized solar cell has taken 24 hours or more to adsorb dye to a titania (titanium dioxide) mesoporous structure by using the dipping method under gravity, and it is almost impossible to impregnate the dye into a mesoporous structure due to a molecular size of the dye or a surface tension of a solvent. Thus, an impregnation process of impregnating dye into a mesoporous structure has received considerable attention in the field of solar cells.

According to an embodiment of the present invention, a method of adsorbing dye uses a supercritical fluid in order to adsorb the dye to a metal oxide particle.

Table 1 shows critical points of various suitable solvents.

**Table 1**

| **Solvent** | **Critical Temperature (°C)** | **Critical Pressure (atm)** |
|---|---|---|
| Carbon dioxide (CO₂) | 31 | 73 |
| Propane | 97 | 42 |
| Ethanol | 241 | 61 |
| Ammonia | 133 | 111 |
| Water | 374 | 218 |

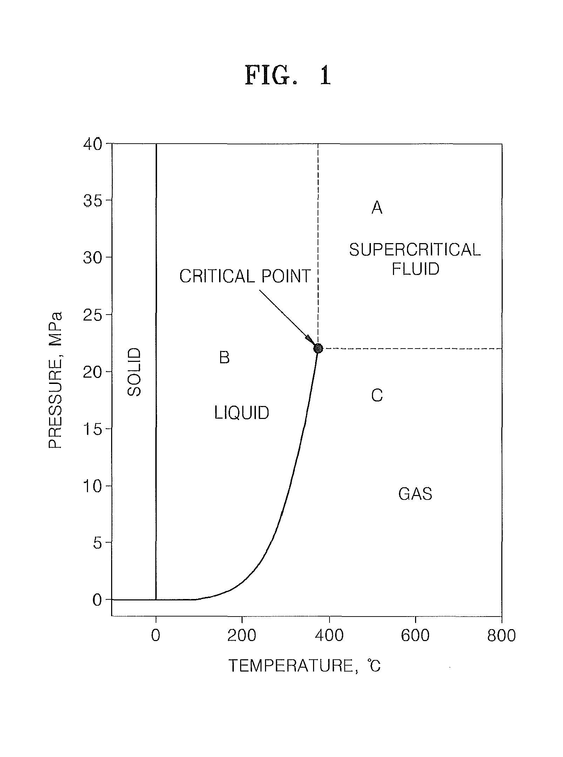

FIG. 1 is a graph for showing a phase change of an exemplary material according to a temperature and a pressure.

As shown in FIG. 1, the material is in a supercritical fluid phase at a critical point or more. The critical point, that is, a critical temperature and a critical pressure varies according to the kind of material. With respect to carbon dioxide, propane, ethanol, ammonia, and water, critical points are shown in Table 1. That is, carbon dioxide is in a supercritical fluid phase at 31°C or more, and 73 atm or more, propane is in a supercritical fluid phase at 97°C or more, and 42 atm or more, ethanol is in a supercritical fluid phase at 241°C or more, and 61 atm or more, ammonia is in a supercritical fluid phase at 133°C or more, and 111 atm or more, and water is in a supercritical fluid phase at 374°C or more, and 218 atm or more.

Supercritical fluid refers to a material in a supercritical fluid phase at a critical temperature or more, and a critical pressure or more, and is different from a solid, liquid, or gas. The property of a material is determined according to the kinds of molecules constituting the material and an interaction between the molecules. Since liquid is incompressible, a distance between molecules is hardly changed, and thus the property of a liquid as a solvent is barely changed according to temperature and pressure.

However, a density of the supercritical fluid is continually changed from a low density like that of a gas to a high density like that of a liquid, and thus solvation and molecular aggregation state as well as solvency, viscosity, diffusion coefficient and thermal conductivity of the supercritical fluid may be adjusted. The density of the supercritical fluid is about 0.3 to about 1.2 times higher than liquid, and is several hundred times higher than gas.

The viscosity of the supercritical fluid is similar to that of gas, and a diffusing velocity of the supercritical fluid is an intermediary value between liquid and gas. As a result, the supercritical fluid is in an active state having a high kinetic energy equivalent to a gas molecule, and a high molecular density equivalent to liquid.

A diffusion force is an important factor for impregnating the mesoporous structure with the dye. The supercritical fluid has a diffusion force that is about 100 times higher than liquid.

According to an embodiment of the present invention, the supercritical fluid is selected from the group consisting of carbon dioxide, ethanol, methanol, propanol, ammonia and water. In one embodiment of the present invention, the supercritical fluid is selected from the group consisting of carbon dioxide, ethanol, methanol, propanol, ammonia, water, and combinations thereof.

The supercritical fluid may be, for example, carbon dioxide, and the dye may be dissolved in ethanol, methanol or water so as to be used.

The method may be performed at a temperature of about 60 to about 80°C (or of 60 to 80°C) and/or at a pressure of about 100 to about 130 bar (or of 100 to 130 bar).

These ranges are determined in consideration of handling convenience of the supercritical fluid, an amount of adsorbed dye, and a period of time taken to adsorb the dye.

The metal oxide particle may be TiO₂, SnO₂, WO₃, ZnO, or a composite thereof.

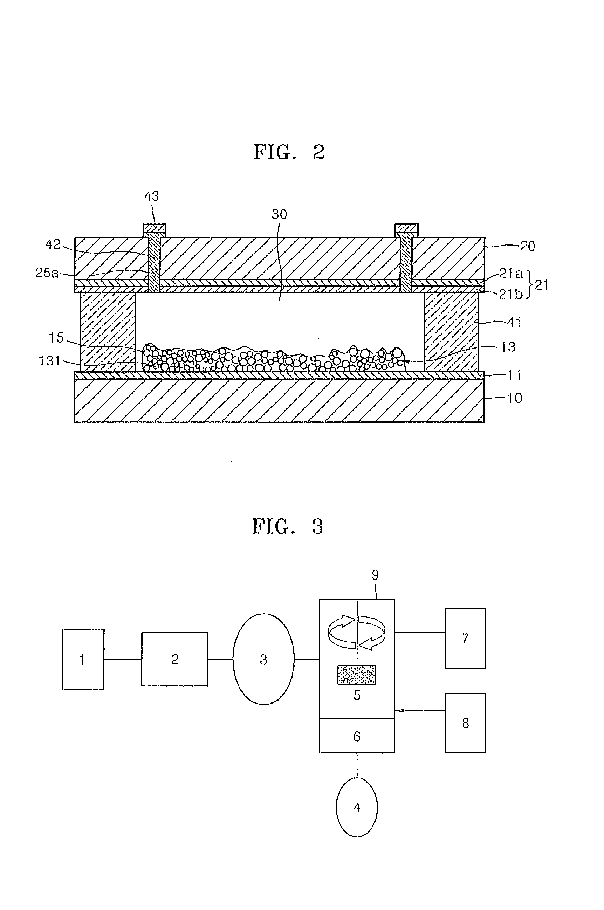

According to an embodiment of the present invention, a dye-sensitized solar cell includes a metal oxide particle which adsorbs dye by using the above method. FIG. 2 is a cross-sectional view of a dye-sensitized solar cell according to an embodiment of the present invention.

Referring to FIG. 2, the dye-sensitized solar cell according to the present embodiment includes a first substrate 10 on which a first electrode 11, a porous layer 13 and dye 15 are formed, and a second substrate 20 on which a second electrode 21 is formed, wherein the first substrate 10 and the second substrate 20 face each other, and an electrolyte 30 is disposed between the first electrode 11 and the second electrode 21. A separate case may be disposed on the outside of the first substrate 10 and the second substrate 20. The dye-sensitized solar cell will now be described in more detail.

The first substrate 10 functioning as a support for supporting the first electrode 11 is formed to be transparent so that external light may be incident thereon. Thus, the first substrate 10 may be formed of glass and/or plastic. Examples of the plastic may include poly ethylene terephthalate (PET), poly ethylene naphthalate (PEN), poly carbonate (PC), poly propylene (PP), poly imide (PI), tri acetyl cellulose (TAC), or the like.

The first electrode 11 formed on the first substrate 10 may be formed of at least one transparent material selected from indium tin oxide, indium oxide, tin oxide, zinc oxide, sulfur oxide, oxyfluoride, ZnO-Ga₂O₃, ZnO-Al₂O₃, and combinations thereof. The first electrode 11 may include a single layer or laminated layers including the transparent material.

The porous layer 13 is formed on the first electrode 11. The porous layer 13 includes metal oxide particles 131 that are formed using a self-assembly method and have a very fine and uniform average diameter. The porous layer 13 may have very fine and uniform pores, thus giving it nanoporous properties. An average diameter of the pores of the porous layer 13 may be in the range of about 7.5 to about 15 nm (or of 7.5 to 15 nm). As the porous layer 13 has an appropriate average pore size, the electrolyte 30 may be easily moved, and the necking properties of the metal oxide particles 131 may be increased.

In the present embodiment, the porous layer 13 may have a thickness in the range of about 10 to about 3000 nm (or of 10 to 3000 nm), in particular, about 10 to about 1000 nm (or of 10 to 1000 nm). However, the porous layer 13 is not limited thereto, and may vary along with technological developments.

The metal oxide particles 131 may be formed of at least one selected from the group consisting of titanium oxide, zinc oxide, tin oxide, strontium oxide, indium oxide, iridium oxide, lanthanum oxide, vanadium oxide, molybdenum oxide, tungsten oxide, niobium oxide, magnesium oxide, aluminium oxide, yttrium oxide, scandium oxide, samarium oxide, gallium oxide, strontium titanium oxide, and combinations thereof. The metal oxide particles 131 may be formed of TiO₂ as titanium oxide, SnO₂ as tin oxide, WO₃ as tungsten oxide, ZnO as zinc oxide, or a composite thereof.

The dye 15 for absorbing external light to generate excited electrons is adsorbed to a surface of the porous layer 13.

The dye 15 may be adsorbed using the supercritical fluid, as described above.

The second substrate 20 facing the first substrate 10 may function as a support for supporting the second electrode 21, and may be formed to be transparent. The second substrate 20 may be formed of glass and/or plastic, like the first substrate 10.

The second electrode 21 formed on the second substrate 20 may be formed to face the first electrode 11, and may include a transparent electrode 21a and a catalyst electrode 21b.

The transparent electrode 21a may be formed of a transparent material such as indium tin oxide, fluoro tin oxide, antimony tin oxide, zinc oxides, tin oxide, ZnO-Ga₂O₃, and/or ZnO-Al₂O₃. In this case, the transparent electrode 21a may include a single layer or a laminated layer including the transparent material. The catalyst electrode 21b may activate a redox couple, and may be formed of platinum (Pt), ruthenium (Ru), palladium (Pd), iridium (Ir), rhodium (Rh), osmium (Os), carbon (C), WO₃, TiO₂, or the like.

The first substrate 10 and the second substrate 20 are adhered to each other by using an adhesive agent 41. The electrolyte 30 is injected into a hole 25a formed through the second substrate 20 and the second electrode 21 so as to be impregnated between the first electrode 11 and the second electrode 21. The electrolyte 30 is uniformly dispersed in the porous layer 13. The electrolyte 30 accepts electrons from the second electrode 21 by an oxidation-reduction reaction, and transfers the electrons to the dye 15. The hole 25a formed through the second substrate 20 and the second electrode 21 is sealed by using an adhesive agent 42 and a cover glass 43.

Hereinafter, embodiments of the present invention will be described in more detail with reference to the following examples.

### Dye Adsorption

### Example 1

Glass coated with TiO₂ was prepared, and then placed in a supercritical device reactor as illustrated in FIG. 3. Referring to FIG. 3, the supercritical device reactor includes a fluid reservoir 1 as a supercritical fluid source, a chiller 2 for chilling the supercritical fluid source, a high pressure pump 3 for controlling the pressure and flow rate of supercritical fluid, an extraction vessel 9 containing a sample 6 positioned therein and including a propeller 5 installed thereto, a thermostat 8 for maintaining the extraction vessel 9 at a set or predetermined temperature, a process controller 7 for maintaining a constant pressure required in the extraction vessel 9, and a mini pump 4 for sending a supercritical fluid to the sample 6 by using internal air and adsorbing the supercritical fluid.

Then, dye in which Ruthenium 535 bis-TBA (available from Solaronix) was dissolved in ethanol to have a concentration of 0.3 M was put in the supercritical device reactor, and then carbon dioxide was injected into the supercritical device reactor.

Carbon dioxide was changed to a supercritical fluid at a temperature of 70°C and a pressure of 120 bar, and dye was adsorbed in a titania mesoporous structure for 30 minutes.

### Example 2

Dye was adsorbed in the same manner as in Example 1 except that carbon dioxide was changed to a supercritical fluid at a temperature of 50°C, and a pressure of 120 bar.

### Comparative Example 1

Dye was adsorbed using a dipping method for 24 hours at a temperature of 50°C, and a pressure of 1 bar without using a supercritical device reactor. Glass coated with TiO₂ was prepared, and this was dipped into dye in which Ruthenium 535 bis-TBA (available from Solaronix) was dissolved in ethanol to have a concentration of 0.3 M, at room temperature.

Adsorbed amounts of Examples 1 and 2, and Comparative Example 1 are shown in Table 2.

**Table 2**

| | **Example 1** | **Example 2** | **Comparative Example 1** |
|---|---|---|---|
| Adsorbed Amount (mol/cm²) | 2.70×10⁷ | 2.07×10⁷ | 2.14×10⁷ |

Referring to Table 2, the adsorbed amount of Example 1 or Example 2 was equivalent to or much greater for a shorter period of time than in Comparative Example 1.

### Preparation of Dye-Sensitized Solar Cell

### Example 3

A dispersion solution of titanium oxide particle having a diameter of about 10 nm was coated on a 1cm² area conductive film formed of ITO as a first electrode by using a doctor blade method, and then heat treatment and sintering processes were performed on the resulting material for 30 minutes at a temperature of 450°C to prepare a porous layer having a thickness of 10 µm.

Then, the resulting material was placed in a supercritical device reactor as illustrated in FIG. 3, dye in which Ruthenium 535 bis-TBA (available from Solaronix) was dissolved in ethanol was put in the supercritical device reactor, and then carbon dioxide was injected into the supercritical device reactor.

The carbon dioxide was changed to supercritical fluid at a temperature of 70°C, and a pressure of 120 bar, and then the dye was adsorbed in a titania mesoporous structure for 30 minutes.

Then, to prepare a first electrode on which a light absorbing layer is formed, the porous layer to which the dye was adsorbed was washed by ethanol and dried at room temperature.

With regard to a second electrode, a second conductive film formed of Pt was formed on a first conductive film formed of ITO by using a sputtering method, and then fine holes for injecting an electrolyte solution were formed by a drill having a diameter of 0.75 mm.

A support including a thermoplastic polymer film (Surlyn, DuPont, USA) having a thickness of 60µm was put between the first electrode including the porous layer and the second electrode, and the first electrode and the second electrode were compressed onto each other for 9 seconds at a temperature of 100°C to adhere the first electrode and the second electrode to each other. Then, acetonitrile electrolyte including LiI (0.5 M) and I (0.05 M) was injected through the fine holes formed in the second electrode, and the fine holes were sealed by a cover glass and the thermoplastic polymer film to prepare a dye-sensitized solar cell.

### Example 4

A dye-sensitized solar cell was prepared in the same manner as in Example 3 except that carbon dioxide was changed to a supercritical fluid at a temperature of 50°C, and a pressure of 120 bar during the dye adsorption.

### Comparative Example 2

A dye-sensitized solar cell was prepared in the same manner as in Example 3 except that the supercritical device reactor was not used during the dye adsorption, and dye was adsorbed using a dipping method for 24 hours at a temperature of 50°C, and at a pressure of 1 bar.

Current densities, open circuit voltages, fill factors and efficiencies of the dye-sensitized solar cells prepared in Examples 3 and 4, and Comparative Example 2 are shown in Table 3.

**Table 3**

| | **Current Density** | **Open circuit voltage** | | |
|---|---|---|---|---|
| | **(Jsc)** | **(Voc)** | **Fill factor (FF)** | **Efficiency (%)** |
| | **(mAcm⁻²)** | **(V)** | | |
| Example 3 | 10.18 | 0.78 | 76 | 6.0 |
| Example 4 | 10.05 | 0.76 | 73 | 5.5 |
| Comparative | 11.83 | 0.76 | 73 | 6.5 |
| Example 2 | | | | |

Referring to Table 3, Example 3 and Example 4 appear to be broadly equivalent to Comparative Example 2 in terms of the current density, open circuit voltage, fill factor and efficiency.

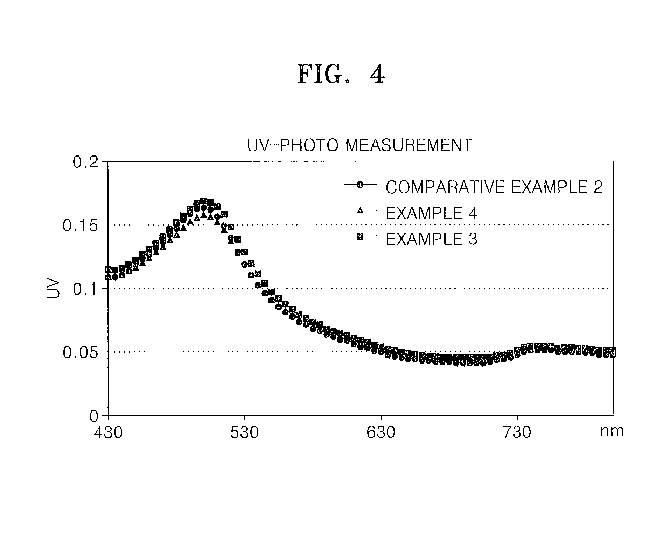

FIG. 4 is a graph showing an optical density for each wavelength of the dye-sensitized solar cells prepared in Examples 3 and 4, and Comparative Example 2.

Referring to FIG. 4, the dye-sensitized solar cells prepared in Examples 3 and 4, and Comparative Example 2 have optical densities having the same pattern.

As described above, according to one or more of the above embodiments of the present invention, a long processing period of time may be reduced by impregnating and adsorbing a large amount of dye to a mesoporous (nanoporous) structure by using a supercritical fluid.

While the present invention has been described in connection with certain exemplary embodiments, it is to be understood that the invention is not limited to the disclosed embodiments, but, on the contrary, is intended to cover various modifications and equivalent arrangements included within the scope of the appended claims.

## Claims

1. A method of adsorbing dye to a metal oxide particle comprising:
adsorbing the dye to the metal oxide particle by using a supercritical fluid.

2. The method of claim 1, wherein the supercritical fluid is selected from the group consisting of carbon dioxide, ethanol, methanol, propane, ammonia and water.

3. The method of claim 1 or 2, wherein the supercritical fluid comprises carbon dioxide, and wherein, before adsorbing the dye to the metal oxide particle, the method comprises dissolving the dye in ethanol, methanol or water.

4. The method of any one of claims 1 to 3, wherein the method is performed at a temperature in a range of about 60 to about 80°C.

5. The method of any one of the preceding claims, wherein the method is performed at a pressure in a range of about 100 to about 130 bar.

6. The method of any one of the preceding claims, wherein the metal oxide particle comprises TiO₂, SnO₂, WO₃, ZnO, or a composite thereof.

7. The method of any one of the preceding claims, comprising changing a material into a supercritical fluid prior to adsorbing the dye to the metal oxide particle.

8. A dye-sensitized solar cell comprising a metal oxide particle and a dye adsorbed in the metal oxide particle by using a supercritical fluid.

9. The dye-sensitized solar cell of claim 8, wherein the metal oxide particle comprises TiO₂, SnO₂, WO₃, ZnO, or a composite thereof.

10. The dye-sensitized solar cell of claim 8, wherein the supercritical fluid is selected from the group consisting of carbon dioxide, ethanol, methanol, propane, ammonia and water.

11. The dye-sensitized solar cell of claim 8, wherein the supercritical fluid comprises carbon dioxide, and the dye is a dye dissolved in ethanol, methanol or water before being adsorbed by the metal oxide particle.

12. The dye-sensitized solar cell of claim 8, wherein the dye is adsorbed to the metal oxide particle at a temperature in a range of about 60 to about 80°C.

13. The dye-sensitized solar cell of claim 8, wherein the dye is adsorbed to the metal oxide particle at a pressure in a range of about 100 to about 130 bar.

14. The dye-sensitized solar cell of claim 8, wherein the dye is adsorbed to the metal oxide particle at a temperature in a range of about 60 to about 80°C, and at a pressure in a range of about 100 to about 130 bar.
